# EUROPEAN PATENT APPLICATION

(11) **EP 4 535 952 A1**
(43) Date of publication of application: **09.04.2025**
(21) Application number: 23202128.7
(22) Date of filing: 06.10.2023
(51) Int. Cl.: H10B 43/30, H10B 43/27, H01L 21/28, H01L 29/792

(54) **A METHOD FOR FORMING A MEMORY STRUCTURE FOR A 3D NAND FLASH MEMORY**

(71) Applicant: Imec VZW, 3001 Leuven (BE)
(72) Inventor: RACHIDI, Sana, 3000 Leuven (BE); ROSMEULEN, Maarten, 9000 Gent (BE); ARMINI, Silvia, 3001 Heverlee (BE)
(74) Representative: Lind Edlund Kenamets Intellectual Property AB

(57) **Abstract**

According to an aspect, there is provided a method for forming a memory structure (1) for a 3D NAND flash memory, the method comprising:
forming a layer stack (10) over a substrate (2);
forming first recessed areas (18) in a sidewall surrounding a memory hole (4) in the layer stack by laterally etching back inter-gate spacer layers (12) of the layer stack;
forming sacrificial layers (20) in the first recessed areas (18);
forming second recessed areas (22) in the sidewall by laterally etching back gate layers (14) of the layer stack;
forming a lateral memory stack (27) in each second recessed area (22) by selectively depositing, in the second recessed areas, a blocking oxide (24) and, subsequently, a charge trap material (26);
removing the sacrificial layers by etching from the memory hole;
re-growing the inter-gate spacer layers such that the lateral memory stacks are vertically separated by the re-grown inter-gate spacer layers;
forming a tunneling oxide layer (30) in the memory hole; and
forming a channel layer (32) along the tunneling oxide layer.

## Description

### TECHNICAL FIELD

The present invention generally relates to a method for forming a memory structure for a 3D NAND flash memory.

### BACKGROUND

The bit density in the 3D NAND flash memory road map increases every year. This far, the increase has been enabled by increasing the number of stacked memory cells along the vertical dimension. However, this route is becoming increasingly difficult and costly. Hence, there is increasing interest in techniques for scaling the cells along the vertical dimension. Vertical scaling ("z-pitch scaling") is achieved by reducing the thickness of the layers in the layer stack, e.g. the word line (gate) layers and oxide inter-gate spacer layers.

Current 3D NAND technology is often based on the so-called charge trap cell utilizing a charge trap layer (e.g. of SiN) as a storage layer. Traditionally, the charge trap layer has been deposited as a continuous layer along the sidewall of the memory hole in the layer stack. Z-scaling results in a reduced inter-cell separation which in turn may reduce the retention performance of the continuous charge trap layer. There is hence a need for scalable techniques allowing forming of an interrupted charge trap layer such that each memory cell may be provided with a separate charge trap layer.

### SUMMARY

It is an object of the present invention to provide a method for forming a memory structure suitable for a 3D NAND flash memory, allowing reliable forming of an interrupted / cut charge trap layer also at aggressive z-pitch scaling.

Hence, according to an aspect of the present invention, there is provided a method for forming a memory structure for a 3D NAND flash memory, the method comprising:
forming a layer stack over a substrate, the layer stack comprising an alternating sequence of gate layers and inter-gate spacer layers;
forming first recessed areas in a sidewall surrounding a memory hole in the layer stack by laterally etching back the inter-gate spacer layers relative the gate layers from the memory hole;
forming sacrificial layers in the first recessed areas;
forming second recessed areas in the sidewall by laterally etching back the gate layers relative the sacrificial layers from the memory hole;
forming a lateral memory stack in each second recessed area by selectively depositing, in the second recessed areas, a blocking oxide and, subsequently, a charge trap material, wherein the sacrificial layers define deposition-inhibiting areas for the selective deposition of the blocking oxide and the charge trap material;
removing the sacrificial layers by etching from the memory hole;
after removing the sacrificial layers, re-growing the inter-gate spacer layers such that the lateral memory stacks are vertically separated by the re-grown inter-gate spacer layers;
after re-growing the inter-gate spacer layers, forming a tunneling oxide layer in the memory hole; and
forming a channel layer along the tunneling oxide layer.

Thus, the method according to the present aspect enables forming of a memory structure comprising vertically separated lateral memory stacks, each comprising a discrete charge trap layer, in particular a respective discrete charge trap layer for each gate layer or, equivalently, for each memory cell.

Rather than depositing a continuous charge trap layer and subsequently "cutting" the charge trap layer into a number of discrete portions by etching, the method "directly" deposits the discrete charge trap layers using an area selective deposition process (ASD), wherein the sacrificial layers are used to define deposition-inhibiting areas ("non-growth areas"). Deposition of the charge trap material in areas vertically between the gate layers may hence be avoided, thus obviating the need for cutting the charge trap material by etching. By obviating the need for etching, the thickness dimension of the charge trap layers (as seen along the lateral dimension) may be precisely controlled by maintaining the growth conditions of the selective deposition until a target thickness has been achieved. The preceding discussion applies correspondingly to the blocking oxide.

Since the inter-gate spacer layers are formed of a dielectric material (typically an oxide) it is envisaged that depositing the blocking oxide and the charge trap material selectively in the second recessed areas (i.e. in vertical levels of the gate layers) without any appreciable concurrent deposition on the gate spacer layers would be challenging. However, by etching back the inter-gate spacer layers to form the first recessed areas in the sidewall and then forming sacrificial layers in the first recessed areas (e.g. filling the first recessed areas with sacrificial layer material), a considerably improved area selectivity may be achieved. That is, the sacrificial layer material may be selected to facilitate the area selective deposition without regard to its suitability in a finished functional memory device. In general, the sacrificial layers may be formed of a sacrificial layer material selected to be deposition-inhibiting for the selective deposition of the blocking oxide and the charge trap material, and to be etchable selectively to the charge trap material, the blocking oxide and the material of the gate layer (e.g. the sacrificial layer material may be etched at a greater rate than each of the charge trap material, the blocking oxide and the material of the gate layer).

A further advantage of the deposition-inhibiting properties of the sacrificial layers is that the risk for pinch-off of the second recessed areas by either the blocking oxide or charge trap material deposition may be avoided.

In some embodiments, forming the sacrificial layers comprises conformally depositing sacrificial material to fill the first recessed areas and cover the sidewall of the memory hole, and etching back the sacrificial material to expose end surfaces of the gate layers at the sidewall. A conformal deposition of the sacrificial material allows the first recessed areas to be reliable filled. The subsequent etch back of the sacrificial material enables sacrificial material deposited outside the first recessed areas to be removed.

In some embodiments, forming the sacrificial layers instead comprises selectively depositing, in the first recessed areas, a sacrificial material to fill the first recessed areas. Hence, the sacrificial material may, like the blocking oxide and the charge trap material, be deposited using an ASD process. During the ASD of the sacrificial material, the gate layers may define deposition-inhibiting areas ("non-growth areas") while the (etched-back) inter-gate spacer layers define deposition-promoting areas.

In some embodiments, the blocking oxide is grown laterally in the second recessed areas to a thickness in a range of 4-12 nm..

In some embodiments, the charge trap material is grown laterally in the second recessed areas to a thickness in a range of 4-8 nm.

In some embodiments, the gate layers are nitride-comprising layers, such as SiN layers, or polysilicon-comprising layers. Polysilicon-comprising gate layers (e.g. highly doped) may be used as functional gates in the final devices. Nitride-comprising gate layers allows final functional gates to be formed in a replacement metal gate (RMG) process.

In some embodiments, the inter-gate spacer layers are oxide-comprising layers, such as SiO₂ layers.

In some embodiments, the sacrificial layers are metal oxide-layers, such as Al₂O₃ or TiO₂ layers, metal-nitride layers, such as AlN or TiN layers, metal layers, such as Co, Ru, Cu, W or Mo layers, or carbon-comprising layers, such as amorphous carbon or organic spin-on layers. Sacrificial materials of any of these types facilitates process control as they tend to define deposition-inhibiting surfaces with respect to ASD of the blocking oxide and the charge trap material. These sacrificial materials further enable etch selectivity with respect to the charge trap material, the blocking oxide and the material of the gate layer (be it polysilicon or a nitride-comprising material). This applies in particular to carbon-comprising layers, such as amorphous carbon or organic spin-on layers.

In some embodiments, the method further comprises, prior to depositing the blocking oxide, functionalizing surface portions of the etched back gate layers in the second recessed areas and thereafter depositing the blocking oxide on the functionalized surface portions.

Thereby, the surface portions of the etched back gate layers in the second recessed areas may be made more reactive with respect to the deposition process and hence improve the selectivity of the deposition on these surface portions.

By "functionalizing" a surface portion with respect to a subsequent deposition process is hereby meant any treatment process which causes said surface portion to become increasingly reactive with respect to the deposition process. The surface portions may thus be provided with an increased tendency to react with one or more precursors of the deposition processes. Thereby, nucleation of the deposited material (e.g. blocking oxide) on the functionalized surface portions may be promoted.

In some embodiments, the step of functionalization comprises depositing a deposition-promoting layer on the surface portions of the etched back gate layers in the second recessed areas. A deposition-promoting layer (i.e. "seed layer") may hence be formed and thus improve the area selectivity for the subsequent selective deposition of the blocking oxide.

In some embodiments, the method further comprises, prior to depositing the blocking oxide, performing a treatment process adapted to passivate exposed surface portions of the sacrificial layers with respect to the selective deposition of the blocking oxide and the charge trap material. Thereby, the deposition-inhibiting properties of the exposed surface portions of the sacrificial layers may be increased with respect to the respective ASD processes for the blocking oxide and the charge trap material. The exposed surface portions of the sacrificial layers may thus be provided with a reduced tendency to react with one or more precursors of the deposition processes. Thereby, nucleation of the blocking oxide and the charge trap material on the sacrificial layers may be further counteracted. It is to be noted that a treatment process may be performed in addition to, or instead of, the above discussed functionalizing-step.

In some embodiments, the method further comprises selectively depositing, in the second recessed areas, a dielectric liner on the gate layers, and subsequently selectively depositing the blocking oxide on the dielectric liner.

The deposition of the lateral memory stack may hence be preceded with a deposition of a dielectric liner on the etched-back gate layers (or on the deposition-promoting layer if functionalized in accordance with the preceding embodiments). The dielectric liner may form a gate dielectric between the gate layers and the lateral memory stack, on its own or in combination with a further gate dielectric deposited during a subsequent replacement metal gate (RMG) process. The dielectric liner may in particular be formed of a high k dielectric material.

In some embodiments, the gate layers (e.g. nitride-comprising gate layers) are sacrificial gate layers and the method further comprises, subsequent to depositing the blocking oxide and the charge trap material, replacing the sacrificial gate layers by a replacement metal gate stack. The sacrificial gate layers may thus be replaced with functional metal gate stacks by an RMG process. The sacrificial gate layers may be removed by etching back the sacrificial gate layers from a second hole in the layer stack, different from the memory hole, and subsequently forming a replacement metal gate stack replacing the sacrificial gate layers.

In some embodiments, the method further comprises selectively depositing, in the second recessed areas, a dielectric liner on the gate layers, and subsequently selectively depositing the blocking oxide on the dielectric liner, and using the dielectric liner as an etch stop layer when removing the sacrificial gate layers to be replaced by the replacement metal gate stack. The lateral memory stack, in particular the blocking oxide, may thus be protected from etching chemistries used when removing the sacrificial gate layers as part of the RMG process. A further advantage related to Z-scaling is that the limited vertical space available for the metal gate stack need not also accommodate a gate dielectric.

### BRIEF DESCRIPTION OF THE DRAWINGS

This and other aspects of the present invention will now be described in more detail, with reference to the appended drawings showing embodiments of the present invention.
Fig. 1a-b schematically shows a schematic cross-sectional view, and a top-down view, respectively, of a starting structure for forming a memory structure according to an embodiment.
Fig. 2 shows the structure after forming first recessed areas.
Fig. 3 shows the structure after forming sacrificial layers in the first recessed areas.
Fig. 4 shows the structure after forming second recessed areas.
Fig. 5 shows the structure after depositing blocking oxide in the second recessed areas.
Fig. 6 shows the structure after depositing charge trap material in the second recessed areas.
Fig. 7 shows the structure after removing the sacrificial layers.
Fig. 8 shows the structure after re-growing inter-gate spacer layers.
Fig. 9 shows the structure after forming a tunnelling oxide layer and a channel layer.
Fig. 10 shows a structure after forming a dielectric liner in second recessed areas, prior to depositing a blocking oxide, according to a further embodiment.
Fig. 11 shows a lateral memory stack formed according to Fig. 10.
Fig. 12 shows a lateral memory stack formed according to a further embodiment.
Fig. 13 illustrates forming of sacrificial layers according to a further embodiment.

### DETAILED DESCRIPTION

Embodiments of a method for forming a memory structure for a 3D NAND flash memory, such as a 3D-Gate-All-Around-NAND (3D GAA NAND), will now be described with reference to the drawings. The drawings are only schematic and the relative dimensions of some structures and layers may be exaggerated and not drawn to scale. Rather the dimensions may be adapted for illustrational clarity and to facilitate understanding. When present in the figures, the indicated axes X, Y and Z consistently refer to a first horizontal or lateral direction, a second horizontal or lateral direction, and a vertical direction, respectively. As used herein, the terms "horizontal" and "lateral" refer to directions parallel to (a main surface of) a supporting substrate of the memory structure. The term "vertical" refers to a direction parallel to a normal direction of (the main surface of) the substrate, i.e. transverse to the substrate.

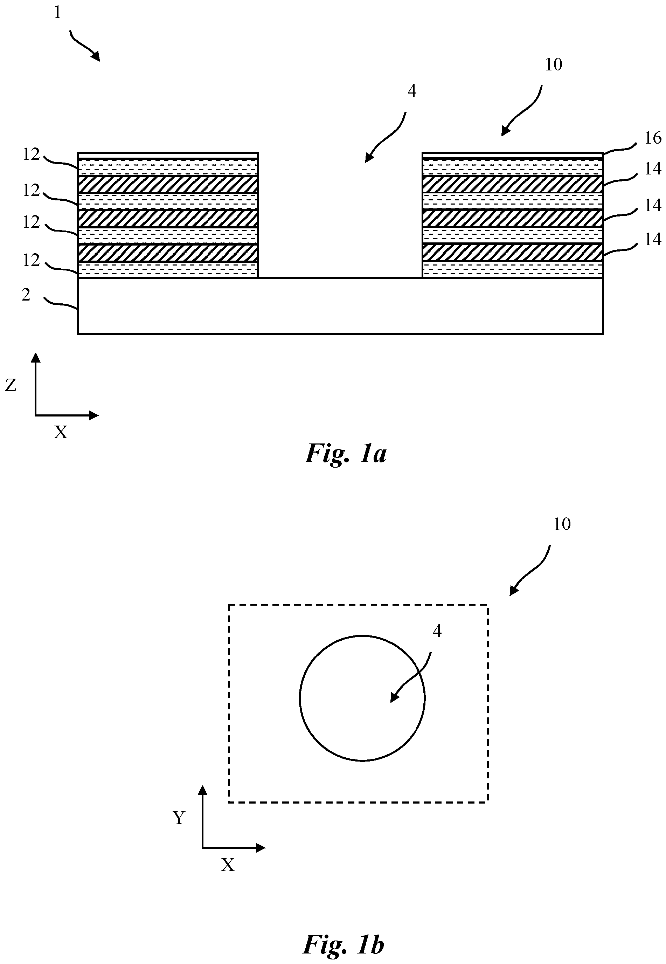

Fig. 1a-b schematically shows a schematic cross-sectional view, and a top-down view, respectively, of a structure 1 at an initial stage of the method. The structure 1 comprises a layer stack 10 representing a precursor or starting structure for the memory structure, to be subjected to the processing steps of the method disclosed in the following.

The layer stack 10 is formed over a substrate 2 and comprises an alternating sequence of gate layers 14 and inter-gate spacer layers 12.

The substrate 2 may be a conventional substrate, suitable for semiconductor processing and for supporting a memory structure for a 3D NAND flash memory. The substrate 2 may for instance be a Si substrate, a Ge substrate or a SiGe substrate. Other examples include a silicon-on-insulator (SOI) substrate, a GeOI substrate or a SiGeOI substrate.

The gate layers 14 may be nitride-comprising layers, such as SiN layers, thus forming sacrificial gate layers 14 intended to be replaced by an RMG stack in subsequent process steps. The gate layers 14 may also be functional gate layers, e.g. highly doped polysilicon-comprising layers.

The inter-gate spacer layers 12 may be oxide-comprising layers, such as SiO₂ layers or another suitable inter-layer dielectric (e.g. of low-k). The inter-gate spacer layers 12 are arranged in the layer stack 10 to provide vertical separation between the memory cells / word lines of the memory device which is to be formed.

The layer stack 10 may be formed by interchangeably depositing layers of gate material (e.g. nitride) and inter-gate spacer material (e.g. oxide) using deposition processes which per se are known in the art, such as chemical vapor deposition (CVD), physical vapor deposition (PVD) or atomic layer deposition (ALD).

The inter-gate spacer layer 12 and the gate layers 14 may be formed in numbers in accordance with the intended number of stacked memory cells of the memory device. It is to be noted that the number of layers 12, 14 of the illustrated layer stack 10 merely is a non-limiting example and that the method disclosed herein is compatible with stacks of memory cells of essentially any number currently used, or contemplated, in the industry, such as 64, 128, 256 or greater.

The inter-gate spacer layers 12 and the gate layers 14 may each be formed with a respective layer thickness in a range of 5-25 nm, as an example. A z-pitch of the layer stack 10 (i.e. the combined thickness of one inter-gate spacer layer and one gate layer 14) may be in a range from about 45 nm to 15 nm or less.

The layer stack 10 may as shown further comprise a capping layer in the form of a semiconductor layer 16, deposited on top of the top-most inter-gate spacer layer 12. The semiconductor layer 16 may for instance be formed of Si.

After depositing the layers 12 and 14 (and optionally 16) of the layer stack 10, a memory hole 4 may be patterned in the layer stack 14, e.g. by a lithography and etching process. While Fig. 1a-b shows a portion of the layer stack 10 surrounding a single memory hole 4, it is noted that a corresponding memory hole 4 may be patterned at each location where a respective vertical string of memory cells is desired. The memory hole 4 may as shown be formed to extend through each one of the inter-gate spacer layers 12 and gate layers 14 of the layer stack 10. The memory hole 4 may as further shown in the top-down view of Fig. 1b be formed with a circular cross-sectional shape, such that the memory hole 4 may be formed with a substantially circular cylindrical shape. However, the memory hole 4 may also be formed with other cross-sectional shapes, such as an oval or polygonal shape.

While not shown in Fig. 1a, the layer stack 10 may as per se is known in the art further comprise, underneath the layers 12, 14, a sub-stack of a select layer and a source layer for forming a select plate and a source plate, respectively, of the memory device. The select and source layers may hence form a bottom sub-stack of the layer stack 10. The select and source layers may be formed by conventional techniques and materials, e.g. doped semiconductor layers (e.g. polysilicon), and be separated by layers of interlayer dielectric.

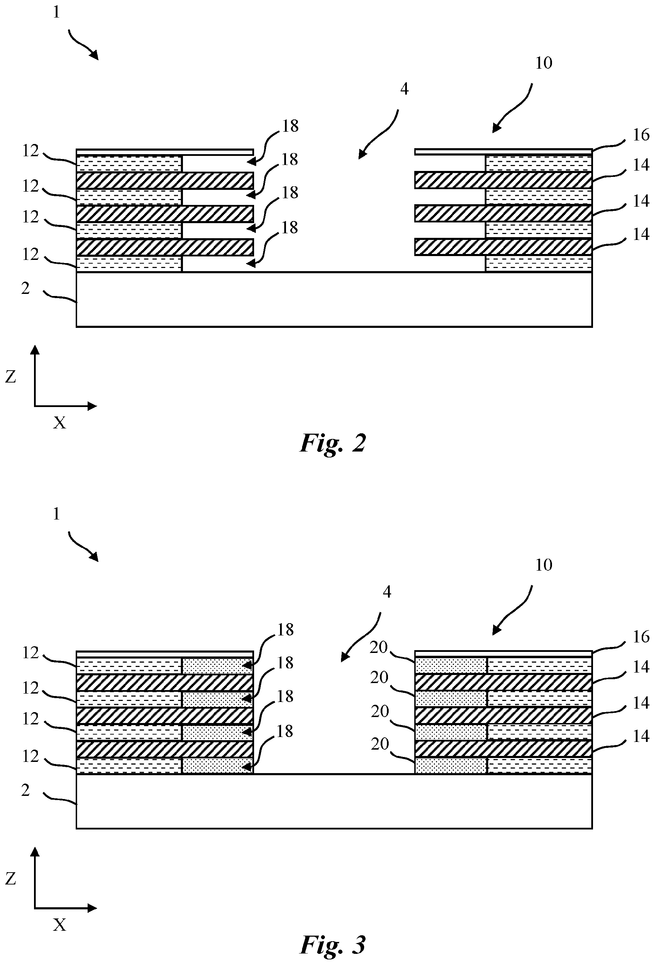

In Fig. 2, first recessed areas 18 have been formed in a sidewall of the layer stack 10 surrounding the memory hole 4 by laterally etching back the inter-gate spacer layers 12 relative the gate layers 14 from the memory hole 4. The inter-gate spacer layers 12 are laterally etched back (along the X-axis) selectively to the gate layers 14 such that the first recessed areas 18 are formed between the gate layers 14. That is, each recessed area / recess of the first recessed areas 18 is formed between a pair of gate layers 14. Due to the circumferential extension of the sidewall about the memory hole 4, the first recessed areas 18 may extend circumferentially about the memory hole 4. In the example of a circular memory hole 4, the first recessed areas 18 may be annular.

The inter-gate spacer layers 12 may be etched back using an etching process adapted to etch the inter-gate spacer layers 12 selectively to the gate layers 14. That is, the etching process may be adapted to etch (i.e. remove) the material (e.g. the oxide material) of the inter-gate spacer layers 12 selectively to the material (e.g. the nitride material) of the gate layers 14, e.g. such that the inter-gate spacer layers 12 may be laterally etched back without causing any substantial etch-back of the gate layers 14. The etching process may be applied to the sidewall of the layer stack 10 via the memory hole 4. Any suitably selective etching process, wet or dry, providing a sufficient lateral etching component with respect to the inter-gate spacer layers 12 (such as an isotropic etching process) may be used.

Providing a semiconductor layer 16 as a top layer of the layer stack 10, ensures that also the top-most inter-gate spacer layer 12 may be recessed. That is, the semiconductor layer 16 may act as an etch mask for top-most inter-gate spacer layer 12 so as to counteract a vertical etch back thereof during the lateral etch-back.

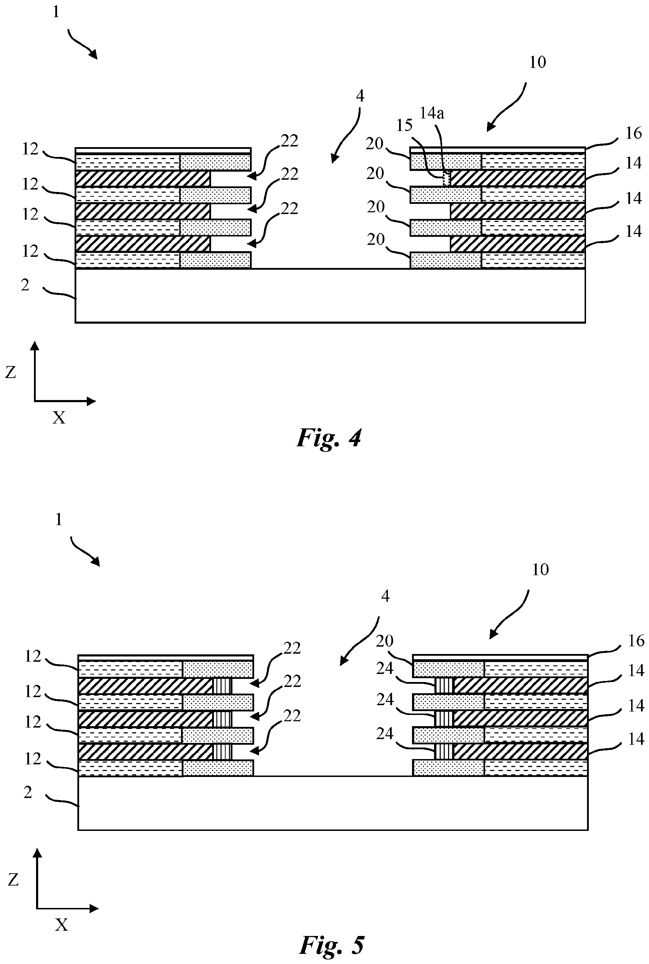

The first recessed areas 18 may be formed with a depth (along the X-axis) matching or exceeding an intended lateral thickness of at least the charge trap material 26 of the lateral memory stacks 27, optionally the intended lateral thickness of the full lateral memory stacks 27, to be formed at the levels of the gate layers 14 (see e.g. Fig. 5-6 discussed below). The depth (i.e. the amount of lateral etch back) of the first recessed areas 18 may for example be in a range of 4-40 nm. The depth of the recessed areas 18 may be controlled by timing the lateral etch back.

In Fig. 3, sacrificial layers 20 have been formed in the first recessed areas 18. The sacrificial layers 20 may as shown be formed to fill (i.e. re-fill) the first recessed areas 18. The sidewall surrounding the memory hole 4 may thus be restored to a substantially straight profile. The sacrificial layers 20 define temporary place holders for the inter-gate space layers 12 which later are to be re-grown. The sacrificial layers 20 are formed of a sacrificial material selected to be deposition-inhibiting for subsequent selective deposition of blocking oxide and the charge trap material. The sacrificial material should further be selected as a material that can be etched selectively to the materials of the lateral memory stacks 27, so that the sacrificial layers 20 can be removed without removing the lateral memory stacks 27 at a later stage of the method. Example materials for the sacrificial layers 20 include metal oxide-layers, such as Al₂O₃ or TiO₂ layers, metal-nitride layers, such as AlN or TiN layers, metal layers, such as Co, Ru, Cu, W or Mo layers, or carbon-comprising layers, such as amorphous carbon or organic spin-on layers.

The sacrificial layers 20 may be formed by selectively depositing the sacrificial material to fill the first recessed areas 18 using an ASD process, wherein the gate layers 14 define non-growth areas while the inter-gate spacer layers 12 growth areas with respect to the ASD process. The deposition of the sacrificial material may be continued until the first recessed areas 18 are filled with the sacrificial material and the inner end surfaces of the sacrificial layers 20 (i.e. facing inwardly with respect to the memory hole 4) are substantially flush with the inner end surfaces of the gate layers 14.

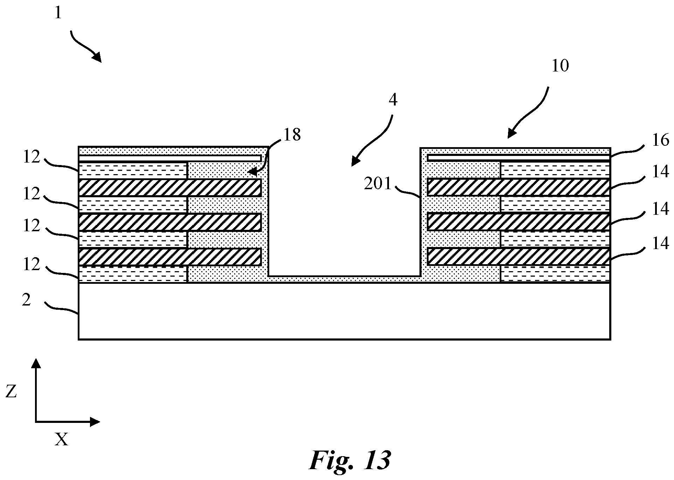

Fig. 13 depicts an alternative approach for forming the sacrificial layers 20 comprising conformally depositing a sacrificial material layer 201 (e.g. by ALD) to fill the first recessed areas 18 and cover the sidewall of the memory hole 4. The sacrificial material layer 201 may subsequently be etched back (e.g. using an isotropic etch) to expose the inner end surfaces of the gate layers 14 at the sidewall of the memory hole 4.

In Fig. 4, second recessed areas 22 have been formed in the sidewall surrounding the memory hole 4 by laterally etching back the gate layers 14 relative the sacrificial layers 20 from the memory hole 4.

The gate layers 14 are laterally etched back (along the X-axis) selectively to the sacrificial layers 20 such that the second recessed areas 22 are formed between the sacrificial layers 20. That is, each recessed area / recess of the second recessed areas 22 is formed between a pair of sacrificial layers 20. Due to the circumferential extension of the sidewall about the memory hole 4, the second recessed areas 22 may extend circumferentially about the memory hole 4. In the example of a circular memory hole 4, the second recessed areas 22 may be annular.

The gate layers 14 may be etched back using an etching process adapted to etch the gate layers 14 selectively to the sacrificial layers 20. That is, the etching process may be adapted to etch (i.e. remove) the material (e.g. the nitride material) of the gate layers 14 selectively to the sacrificial material of the sacrificial layers 20, e.g. such that the gate layers 14 may be laterally etched back without causing any substantial etch-back of the sacrificial layers 20. The etching process may be applied to the sidewall of the layer stack 10 via the memory hole 4. Any suitably selective etching process, wet or dry, providing a sufficient lateral etching component with respect to the gate layers 14 (such as an isotropic etching process) may be used.

The second recessed areas 22 may be formed with a depth (along the X-axis) matching an intended lateral thickness of the lateral memory stacks 27 to be formed at the levels of the gate layers 14 (see e.g. Fig. 5-6 discussed below). The depth (i.e. the amount of lateral etch back) of the second recessed areas 22 may for example be in a range of 6-20 nm. The depth of the second recessed areas 22 may be controlled by timing the lateral etch back.

By forming the second recessed areas 22 with a smaller lateral depth than the first recessed areas 18, the inter-gate spacer layers 12 may be masked during the etch back of the gate layers 14, e.g. since the inter-gate spacer layers 12 then may be masked by the sacrificial layers 20 and the (etched-back) gate layers 14. If this is not the case, the etching process used to etch back the gate layers 14 may advantageously be adapted to etch the material (e.g. the nitride material) of the gate layers 14 selectively to both the sacrificial material of the sacrificial layers 20 and the material (e.g. oxide) of the inter-gate spacer layers 12.

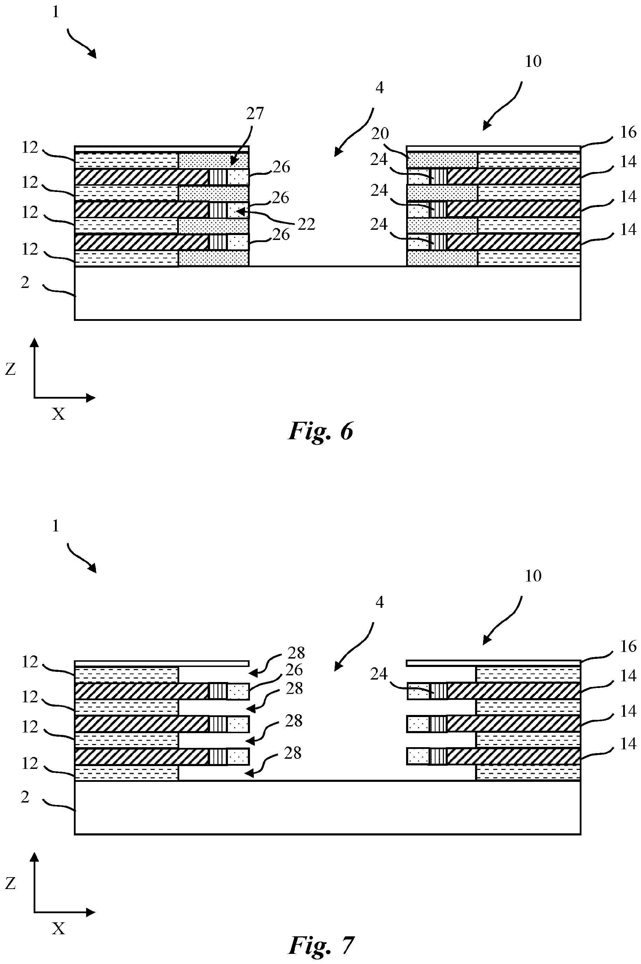

Fig. 5-6 depict steps for forming a lateral memory stack 27 in each second recessed area 22 by selectively depositing, in the second recessed areas 22, a blocking oxide 24 (Fig. 5) and, subsequently, a charge trap material 26 (Fig. 6). Hence, both the blocking oxide 24 and the charge trap material 26 are selectively deposited, wherein the sacrificial layers 20 define deposition-inhibiting areas (non-growth areas) for the selective deposition of the blocking oxide 24 and the charge trap material 26. As the blocking oxide 24 and the charge trap material 26 are selectively deposited in the second recessed areas 22, the blocking oxide 24 may define a discrete blocking oxide layer (which in the following also may be referred to using reference sign 24) in each second recessed area 22 and the charge trap material 26 may form a discrete charge trap layer (which in the following also may be referred to using reference sign 26).

The blocking oxide 24 may comprise or be SiOₓ (e.g. SiO₂), or some other oxide material suitable to be used as a blocking oxide. The blocking oxide 24 may be deposited using any deposition process (e.g. an ALD or CVD process) allowing area-selective deposition of the blocking oxide 24 (e.g. SiO₂) such that the blocking oxide 24 is deposited on growth-promoting or seeding surface portions in the second recessed areas 22 but not on the growth-inhibiting areas defined by the sacrificial layers 20. The growth-promoting surface portions may in particular be defined by the surface portions (i.e. the end surfaces 14a indicated in Fig. 4) of the etched back gate layers 14 exposed in the second recessed areas 22.

The charge trap material 26 may comprise or be SiN (i.e. Si₃N₄). SiN represents an efficient and rational realization of charge trap memory cells. However, it is envisaged that the present method is compatible also with other choices of charge trap material, as long as they may be deposited in an area-selective fashion in the second recessed areas 22, e.g. on the etched-back gate layers 14. The charge trap material 26 may be deposited using any deposition process (e.g. an ALD or CVD process) allowing area-selective deposition of the charge trap material 26 (e.g. SiN) such that the charge trap material 26 is deposited on growth-promoting or seeding surface portions in the second recessed areas 22 but not on the growth-inhibiting areas defined by the sacrificial layers 20. The growth-promoting surface portions may in particular be defined by the already deposited blocking oxide 24.

To facilitate the selective deposition of the blocking oxide 24, the layer stack 10 may be subjected to a treatment step prior to depositing the blocking oxide 24, adapted to functionalize the surface portions / end surfaces 14a of the etched back gate layers 14 in the second recessed areas 22 and thereafter depositing the blocking oxide 24 on the functionalized surface portions in the second recessed areas 22. For instance, as schematically indicated in one of the recessed areas 22 of Fig. 4, the functionalization may comprise depositing a deposition-promoting layer 15 on the surface portions 14a of the etched back gate layers 14 in the second recessed areas 22. Additionally or alternatively, the layer stack 10 may be subjected to a treatment process adapted to passivate exposed surface portions of the sacrificial layers 20 with respect to the selective deposition of the blocking oxide 24 and the charge trap material 26. For instance, as per se is known in the art, some deposition processes favor deposition on hydrogen terminated surfaces (e.g. the deposition process deposits material preferentially on hydrogen terminated surfaces). A treatment process may hence be adapted to increase an occurrence of hydrogen terminated bonds on the gate layers 14 (thus promoting deposition thereon) and/or reduce an occurrence of hydrogen terminated bonds on the sacrificial layers 20 (thus inhibiting deposition thereon). This is however merely one non-limiting example and other techniques are known to the skilled person.

As an illustrative example, the gate layers 14 may be SiN layers and the sacrificial layers 20 may be Al₂O₃ layers, wherein a blocking oxide 24 of SiO₂ may be selectively deposited using a plasma-enhanced ALD (PEALD) process comprising repeatedly performing a deposition cycle of: A) passivation of the sacrificial layers 20 using acetylacetone, B) introducing a Si precursor Bis(diethylamino)silane (BDEAS), and C) providing an O₂ plasma as co-reactant. The acetylacetone will cause grafting of the surface of the Al₂O₃ thus making the surface of the sacrificial layers 20 (but not the SiN of the gate layers 14) relatively inert to the Si precursor, such that the SiO₂ blocking oxide is selectively deposited in the second recessed areas 22. Selective deposition of charge trap material 26 of SiN may be achieved in a corresponding fashion, i.e. using a PEALD process comprising repeatedly performing a deposition cycle of A) passivation of the sacrificial layers 120, B) introducing a Si precursor, and C) providing an N₂ or NH₃ plasma. Various variations of these approaches are contemplated. For instance, the sacrificial layers 20 may be formed of another metal oxide, such as TiO₂. Passivation of sacrificial layers 20 may be achieved using an organic carboxylic acid such as pivalic acid, butyric acid, or the like. Instead of BDEAS some other relatively bulky Si precursor may be used. Furthermore, a thermal ALD process may be used instead of a PEALD process.

The blocking oxide 24 may be grown laterally (along the X-axis) in the second recessed areas 22 to form a blocking oxide layer in each second recessed area 22 with a thickness (along the X-axis) in a range of 4-12 nm. The charge trap material 26 may be grown laterally (along the X-axis) in the second recessed areas 22 to a form a charge trap layer in each second recessed area 22 with thickness (along the X-axis) in a range of 4-8 nm. More generally, the deposition of the charge trap material 26 may be continued until the second recessed areas 22 are filled with the charge trap material and the inner end surfaces of the charge trap material / layers 26 (i.e. facing inwardly with respect to the memory hole 4) are substantially flush with the inner end surfaces of the sacrificial layers 20. The lateral memory stacks 27 may thus fill the lateral depth of the second recessed areas 22, thereby restoring the sidewall surrounding the memory hole 4 to a substantially straight profile.

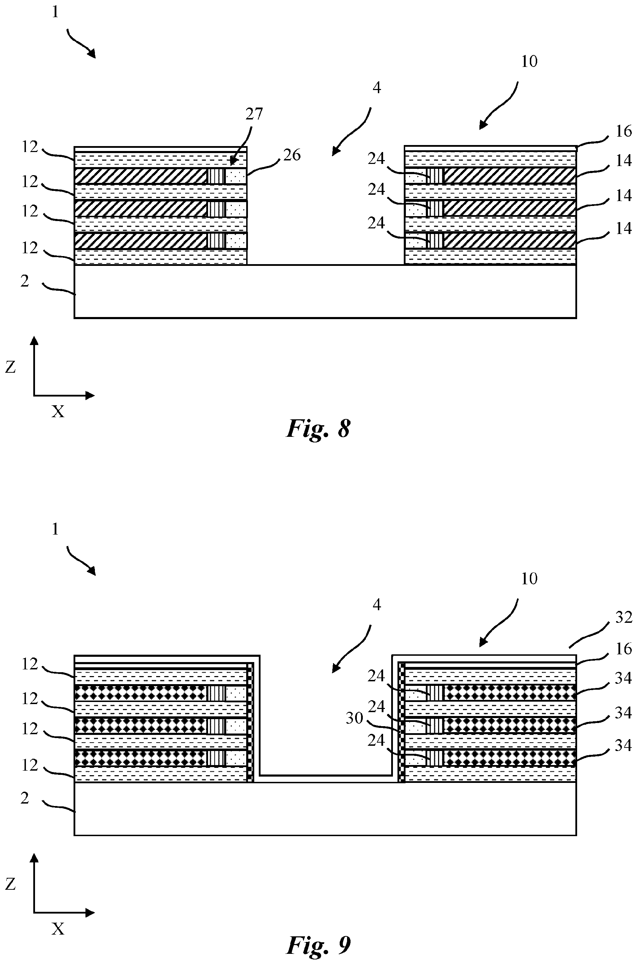

In Fig.7, the sacrificial layers 20 have been removed from the layer stack 10 by etching from the memory hole 4. The sacrificial layers 20 may be removed employing a selective etch, etching the sacrificial material selectively to the charge trap material 26 and the blocking oxide 24. Any suitably selective etching process, wet or dry, providing a sufficient lateral etching component with respect to the sacrificial layers 20 (such as an isotropic etching process) may be used. By removing the sacrificial layers 20, the first recessed areas (in Fig. 8 and onwards labelled 28) may be restored or re-opened.

Fig. 8 depicts the structure 1 after removing the sacrificial layers 20 and re-growing the inter-gate spacer layers 12 in the restored first recessed areas 28. The lateral memory stacks 27 (comprising the blocking oxide 24 and the charge trap material 26) in the second recessed areas 22 are thus vertically separated by the re-grown inter-gate spacer layers 12. The inter-gate spacer layers 12 may be re-grown by depositing the oxide material (e.g. SiO₂) of the inter-gate spacer layers 12, e.g. using a conformal deposition process such as ALD. Both area-selective and non-area selective deposition techniques are possible. For example, a selective oxide-on-oxide deposition process may be used to re-deposit the oxide material on the inter-gate spacer layers 12. Using a non-area selective deposition technique the oxide material may be conformally deposited to fill the first recessed areas 28 and cover the sidewall (e.g. including the charge trap material 26) of the memory hole 4, and subsequently be laterally etched back to expose the inner end surfaces of the charge trap material 26 at the sidewall of the memory hole 4.

In Fig. 9, a tunneling oxide layer 30, and subsequently a channel layer 32, have been formed in the memory hole 4, along the sidewall thereof. The tunneling oxide layer 30 is thus formed along the discrete charge trap layers 26 of the lateral memory stacks 27, more specifically along or in contact with the respective inner end surfaces of the charge trap layers 26). The tunneling oxide layer 30 and the channel layer 32 may be each be conformally deposited, e.g. using a respective ALD process. After depositing the tunneling oxide layer 30, the tunneling oxide layer 30 may be subjected to an anisotropic etch oriented top-down (opposite the direction of the Z-axis) to remove portions of the tunneling oxide layer 30 deposited on horizontally oriented surfaces of the structure 1.

The tunneling oxide layer 30 may be formed of any material conventionally used in the industry for tunneling oxide layers, one non-limiting example being SiON. The channel layer 32 may similarly be formed by any suitable channel material conventionally used in the industry for channel layers, typically a semiconductor material such as Si, SiGe or Ge. While not shown in Fig. 9, the channel layer 32 may present an extension outside of the illustrated portion of the structure 1, to facilitate connection to peripheral semiconductor devices and circuitry, such as select transistors.

If the gate layers 14 are sacrificial gate layers, the method may as shown in Fig. 9 proceed with replacing the sacrificial gate layers 14 by a replacement metal gate stack 34. The sacrificial gate layers 14 may be removed by etching back the sacrificial gate layers 14 from a second hole (not shown) in the layer stack 10 (e.g. denoting the memory hole 4 as a front side hole or opening the second hole may be referred to as a backside hole or opening). The thusly formed lateral cavities formed at the levels of the sacrificial gate layers 14 may subsequently be filled with a replacement metal gate stack replacing the sacrificial gate layers 14. Replacement metal gate stack deposition may as per se is known in the art comprise depositing one or more conductive layers, e.g. metal such as one or more of TiN and W. The deposition of the conductive layer(s) may be preceded by deposition of a (conformal) high-k gate dielectric.

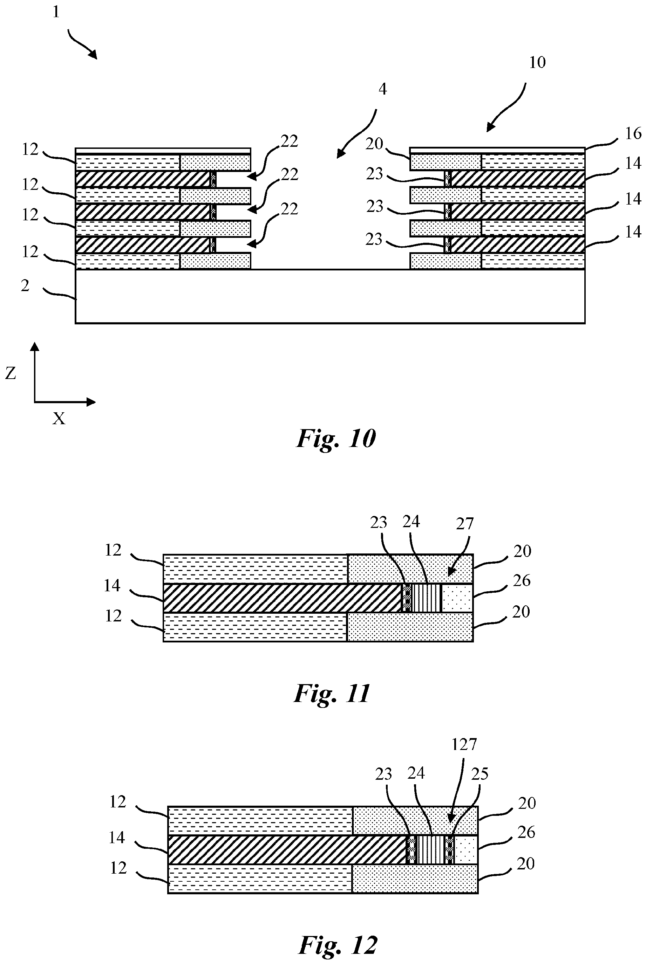

Fig. 10 shows a variation of the preceding process flow, wherein after etching back the gate layers 14 and prior to depositing the blocking oxide 24, a dielectric liner 23 is formed in the second recessed areas 22. The dielectric liner 23 may be high-k dielectric (e.g. Al₂O₃ or HfO₂), wherein the liner 23 may define the gate dielectric. In addition to this function, the dielectric liner 23 may, in the case of an RMG process, be used as an etch stop layer when removing the sacrificial gate layers 14 during the RMG, thereby masking the lateral memory stack 27 from the etching chemistries used when removing the sacrificial gate layers 14.

The dielectric liner 23 may, like the blocking oxide 24, be selectively deposited in the second recessed areas 22, i.e. using a deposition process allowing the liner material of the dielectric liner 23 to deposit selectively on growth-promoting or seeding surface portions in the second recessed areas 22 but not on the growth-inhibiting areas defined by the sacrificial layers 20. The deposition of the dielectric liner 23 may be preceded by one or more treatment processes for functionalization and/or inhibition of the gate layers 14 and sacrificial layers 20, respectively, as discussed above in connection with the selective deposition of the blocking oxide 24. The dielectric liner 23 may accordingly be deposited on the end surfaces 14a (see Fig. 4) of the etched back gate layers 14, or on a deposition-promoting layer 15 formed thereon.

Fig. 11 shows the resulting lateral memory stack 27 after depositing the blocking oxide 24 on the dielectric liner 23, and then charge trap material 26.

Fig. 12 shows a lateral memory stack 127 according to yet a further variation wherein after depositing the blocking oxide 24 and prior to depositing the charge trap material 26, a (second) dielectric liner 25 (e.g. also of a high-k dielectric) has been selectively deposited on the blocking oxide 24 in the second recessed areas 22. The charge trap material 26 has then been selectively deposited on the dielectric liner 25. Each lateral memory stack 127 thus comprises a lateral stack of a blocking oxide 24, a dielectric liner 25 and a charge trap material 26.

The person skilled in the art realizes that the present invention by no means is limited to the embodiments described above. On the contrary, many modifications and variations are possible within the scope of the appended claims.

## Claims

1. A method for forming a memory structure (1) for a 3D NAND flash memory, the method comprising:
forming a layer stack (10) over a substrate (2), the layer stack (10) comprising an alternating sequence of gate layers (14) and inter-gate spacer layers (12);
forming first recessed areas (18) in a sidewall surrounding a memory hole (4) in the layer stack by laterally etching back the inter-gate spacer layers (12) from the memory hole (4);
forming sacrificial layers (20) in the first recessed areas (18);
forming second recessed areas (22) in the sidewall by laterally etching back the gate layers (14) from the memory hole (4);
forming a lateral memory stack (27) in each second recessed area (22) by selectively depositing, in the second recessed areas (22), a blocking oxide (24) and, subsequently, a charge trap material (26), wherein the sacrificial layers (20) define deposition-inhibiting areas for the selective deposition of the blocking oxide (24) and the charge trap material (26);
removing the sacrificial layers (20) by etching from the memory hole (4);
after removing the sacrificial layers (20), re-growing the inter-gate spacer layers (12) such that the lateral memory stacks (27) are vertically separated by the re-grown inter-gate spacer layers (12);
after re-growing the inter-gate spacer layers (12), forming a tunneling oxide layer (30) in the memory hole (4); and
forming a channel layer (32) along the tunneling oxide layer (30).

2. The method according to claim 1, wherein forming the sacrificial layers (20) comprises conformally depositing sacrificial material (201) to fill the first recessed areas (18) and cover the sidewall of the memory hole (4), and etching back the sacrificial material (201) to expose end surfaces of the gate layers (14) at the sidewall.

3. The method according to claim 1, wherein forming the sacrificial layers (20) comprises selectively depositing, in the first recessed areas (18), a sacrificial material to fill the first recessed areas (18).

4. The method according to any one of the preceding claims, wherein the blocking oxide (24) is grown laterally in the second recessed areas (22) to a thickness in a range of 4-12 nm.

5. The method according to any one of the preceding claims, wherein the charge trap material (26) is grown laterally in the second recessed areas (22) to a thickness in a range of 4-8 nm.

6. The method according to any one of the preceding claims, wherein the gate layers (14) are nitride-comprising layers, such as SiN layers, or polysilicon-comprising layers.

7. The method according to any one of the preceding claims, wherein the inter-gate spacer layers (12) are oxide-comprising layers, such as SiO₂ layers.

8. The method according to any one of the preceding claims, wherein the sacrificial layers (20) are metal oxide-layers, such as Al₂O₃ or TiO₂ layers, metal-nitride layers, such as AlN or TiN layers, metal layers, such as Co, Ru, Cu, W or Mo layers, or carbon-comprising layers, such as amorphous carbon or organic spin-on layers.

9. The method according to any one of the preceding claims, further comprising, prior to depositing the blocking oxide (24), functionalizing surface portions (14a) of the etched back gate layers (14) in the second recessed areas (22) and thereafter depositing the blocking oxide (24) on the functionalized surface portions (14a).

10. The method according to claim 9, wherein the step of functionalization comprises depositing a deposition-promoting layer (15) on the surface portions (14a) of the etched back gate layers (14) in the second recessed areas (22).

11. The method according to any one of the preceding claims, further comprising, prior to depositing the blocking oxide, performing a treatment process adapted to passivate exposed surface portions of the sacrificial layers (20) with respect to the selective deposition of the blocking oxide (24) and the charge trap material (26).

12. The method according to any one of the preceding claims, further comprising selectively depositing, in the second recessed areas (22), a dielectric liner (23) on the gate layers (14), and subsequently selectively depositing the blocking oxide (24) on the dielectric liner (23).

13. The method according to any one of the preceding claims, wherein the gate layers (14) are sacrificial gate layers and the method further comprises, subsequent to depositing the blocking oxide and the charge trap material, replacing the sacrificial gate layers (14) by a replacement metal gate stack (34).

14. The method according to claim 13, when dependent on claim 12, further comprising using the dielectric liner (23) as an etch stop layer when removing the sacrificial gate layers (14) to be replaced by the replacement metal gate stack (34).
